# EUROPÄISCHE PATENTSCHRIFT

(11) **EP 0 699 960 B1**
(45) Veröffentlichungstag und Bekanntmachung des Hinweises auf die Patenterteilung: **26.05.1999**
(21) Anmeldenummer: 95113087.1
(22) Anmeldetag: 21.08.1995
(51) Int. Cl.: G03F 7/021

(54) **Lichtempfindliches Gemisch**
Photosensitive composition
Composition photosensible

(30) Priorität: 29.08.1994 DE 4430680
(43) Veröffentlichungstag der Anmeldung: 06.03.1996
(73) Patentinhaber: Agfa-Gevaert AG, 51373 Leverkusen (DE)
(72) Erfinder: Konrad, Klaus-Peter, Dr., D-55218 Ingelheim (DE); Gries, Willi-Kurt, Dr., D-65183 Wiesbaden (DE); Jung, Günter, D-65323 Taunusstein (DE)

(56) Entgegenhaltungen:
- EP-A- 0 008 038
- DE-A- 3 118 039
- DE-A- 3 516 387
- FR-A- 2 238 952
- FR-A- 2 262 813

## Beschreibung

Die Erfindung betrifft ein lichtempfindliches Gemisch, das ein Polykondensationsprodukt eines aromatischen Diazoniumsalzes, ein polymeres Bindemittel und eine niedermolekulare oberflächenaktive Substanz enthält und das sich zur Herstellung von Flachdruckplatten eignet, die durch bildmäßiges Belichten und Auswaschen der unbelichteten Bereiche der lichtempfindlichen Schicht mit Wasser zur Flachdruckform verarbeitet werden können.

Lichtempfindliche Gemische und Aufzeichnungsmaterialien der genannten Gattung sind in der DE-A 26 07 091 (= US-A 4 092170) offenbart. Sie enthalten wasserunlösliche polymere Bindemittel und mindestens 10, bevorzugt 20 bis 40 Gew.-% eines wasserlöslichen oberflächenaktiven Mittels, insbesondere eines quaternären Ammoniumsalzes. Sie lassen sich mit reinem Wasser, zumeist unter mechanischer Unterstützung, entwickeln. Die Druckauflage der damit erhaltenen Druckformen ist jedoch begrenzt. Auch ist wegen des hohen Gehalts an hydrophilem oberflächenaktivem Mittel die Oleophilie eingeschränkt, so daß die Bildstellen erst nach einer größeren Anzahl von Drucken ausreichend Farbe annehmen.

In der EP-B 8038 (= US-A 4 288 520) wird ein lichtempfindliches Aufzeichnungsmaterial beschrieben, das eine Schicht aus einem dispergierbaren wasserunlöslichen Polymer, einem wasserlöslichen Diazoniumsalz-Kondensationsprodukt und einem Netzmittel aufweist. Auch dieses Aufzeichnungsmaterial läßt sich nicht ohne mechanische Unterstützung mit reinem Wasser entwickeln, und selbst dann ist es häufig schwierig, die Schichtreste aus den Nichtbildstellen vollständig zu entfernen.

In der DE-A 30 31 302 (= GB-A 2 081 916) wird ein lichtempfindliches Aufzeichnungsmaterial für die Herstellung von Druckplatten beschrieben, das auf einem Schichtträger eine lichtempfindliche Schicht aus einem wasserlöslichen Diazoniumsalz-Polykondensationsprodukt und darüber eine zweite lichtempfindliche Schicht aus einem wasserunlöslichen Kondensationsprodukt von Diphenylamindiazoniumsalz und Formaldehyd, ausgefällt als Salz einer Benzophenonsulfonsäure, und einem wasserunlöslichen oleophilen Polymer trägt. Das Aufzeichnungsmaterial wird mit Leitungswasser bei erhöhter Temperatur entwickelt. Es ist schwierig, bei dieser Verarbeitung eine saubere Differenzierung nach Bild- und Nichtbildstellen zu erreichen. Auch ist das Aufbringen von zwei Schichten technologisch aufwendig und erfordert besondere Sorgfalt.

Schließlich wird in der DE-A 33 28 019 (= US-A 4 568 628) ein lichtempfindliches Aufzeichnungsmaterial für die Herstellung von Druckplatten beschrieben, das eine lichtempfindliche Schicht aus einem Kondensationsprodukt eines Diazodiarylamins mit Formaldehyd, einem in Wasser dispergierbaren wasserunlöslichen Polymer und einem Dispergiermittel trägt. Das Aufzeichnungsmaterial läßt sich mit Wasser entwickeln. Auch hier führt die Entwicklung nicht immer zu einer sauberen Entfernung der Nichtbildstellen; die Farbannahme beim Druck ist verzögert und die Druckauflage begrenzt.

Aufgabe der Erfindung war es, ein Aufzeichnungsmaterial zur Verfügung zu stellen, aus dem sich durch Entwickeln mit reinem Wasser, ohne mechanische Unterstützung durch Reiben oder Bürsten, eine Druckplatte herstellen läßt. In den Nichtbildbereichen der Druckplatte sollen keine Reste der lichtempfindlichen Schicht zurückbleiben. Die Druckplatte soll beim Andruck schnell Farbe annehmen, nicht zum Tonen neigen und hohe Druckauflagen zulassen. Das Aufzeichnungsmaterial soll zugleich bei hoher Luftfeuchte lange lagerfähig sein.

Erfindungsgemäß wird ein lichtempfindliches Gemisch vorgeschlagen, das ein Polykondensationsprodukt eines aromatischen Diazoniumsalzes, ein polymeres Bindemittel und eine niedermolekulare oberflächenaktive Substanz enthält.

Das erfindungsgemäße Gemisch ist dadurch gekennzeichnet, daß das polymere Bindemittel ein wasserlösliches amphiphiles Polymer mit einem mittleren Molekulargewicht M_{w} von 5000 bis 100000 ist und daß die oberflächenaktive Substanz mindestens eine nichtionische Verbindung mit einem Molekulargewicht von 150 bis 2000 ist.

Gemäß einem anderen Aspekt der Erfindung wird ein lichtempfindliches Aufzeichnungsmaterial für die Herstellung von Druckformen, insbesondere Flachdruckformen vorgeschlagen, das auf einem Schichtträger eine lichtempfindliche Schicht trägt.

Das erfindungsgemäße Aufzeichnungsmaterial ist dadurch gekennzeichnet, daß die lichtempfindliche Schicht aus einem Gemisch der oben angegebenen Zusammensetzung besteht.

Gegenstand der Erfindung ist schließlich auch ein Verfahren zur Herstellung von Druckplatten, in dem man das erfindungsgemäße Aufzeichnungsmaterial bildmäßig belichtet und die unbelichteten Schichtbereiche mit Wasser auswäscht.

Das Gemisch enthält als lichtempfindliche Substanz ein Kondensationsprodukt eines aromatischen Diazoniumsalzes. Derartige Kondensationsprodukte sind u.a. aus der DE-A 12 14 086 (= US-A 3 235384) bekannt. Sie werden im allgemeinen durch Kondensation einer mehrkernigen aromatischen Diazoniumverbindung, vorzugsweise von substituierten oder unsubstituierten Diphenylamin-4-diazoniumsalzen mit aktiven Carbonylverbindungen, vorzugsweise Formaldehyd, in stark saurem Medium, vorzugsweise konzentrierter Phosphorsäure, hergestellt.

In den US-A 3867147 und 4021243 sind Kondensationsprodukte beschrieben, die zusätzlich durch Kondensation entstandene Einheiten enthalten, die von Diazoniumsalzgruppen frei sind und vorzugsweise von aromatischen Aminen, Phenolen, Phenolethern, aromatischen Thioethern, aromatischen Kohlenwasserstoffen, aromatischen heterocyclischen Verbindungen oder organischen Säureamiden abgeleitet sind.

Das Diazoniumsalz-Polykondensationsprodukt enthält somit bevorzugt wiederkehrende Einheiten R-N₂X, die durch Zwischenglieder miteinander verbunden sind, die von kondensationsfähigen Carbonylverbindungen, insbesondere Formaldehyd, abge-leitet sind, wobei R ein mindestens zwei Benzolringe enthaltender aromatischer Rest und X ein Anion ist. Das Diazoniumsalz-Polykondensationsprodukt kann auch aus wiederkehrenden Einheiten A-N₂X und B bestehen, die durch Zwischenglieder, vorzugsweise Methylengruppen miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, einers aromatischen Kohlenwasserstoffs, einer aromatischen heterocyclischen Verbindung oder eines organischen Säureamids ist. Außerdem kann es ein Produkt mit wiederkehrenden Einheiten A-N₂X und B sein, die durch zweibindige, von einer kondensationsfähigen Carbonylverbindung abgeleitete Zwischenglieder verbunden sind. Die Diazoniumsalzeinheiten A-N₂X leiten sich bevorzugt von Verbindungen der Formel (R¹-R²-)ₚR³-N₂X ab, wobei
- X: ein Anion, das eine Löslichkeit in Wasser bewirkt,
- p: eine ganze Zahl von 1 bis 3,
- R¹: einen aromatischen Rest mit mindestens einer zur Kondensation mit aktiver Carbonylverbindung befähigten Position,
- R²: eine Einfachbindung oder eine der Gruppen:
-(CH₂)_{q}-NR⁴-,
-O-(CH₂)ᵣ-NR⁴-,
-S-(CH₂)ᵣ-NR⁴-,
-S-CH₂-CO-NR⁴-,
-O-R⁵-O-,
-O-,
-S- oder
-CO-NR⁴-
worin
q eine Zahl von 0 bis 5,
r eine Zahl von 2 bis 5,
R⁴ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
R⁵ eine Arylengruppe mit 6 bis 12 C-Atomen ist, und
- R³: einen ggf. substituierten (p+1)-wertigen Benzolrest bedeuten.

Der (p+1)-wertige Benzolrest ist bevorzugt mit (C₁-C₄)Alkoxy- oder (C₁-C₆)Alkylgruppen substituiert. p ist bevorzugt 1, was bedeutet, daß R³ bevorzugt eine ggf. substituierte Phenylengruppe ist.

Das Anion X ist vorzugsweise das Chlorid, Sulfat, Phosphat, oder ein ggf. substituiertes Alkansulfonat mit 1-4 Kohlenstoffatomen, z.B. das Methansulfonat oder ein Aminoalkansulfonat, wie es in der EP-A 224 162 beschrieben ist. Wenn das (C₁-C₄)Alkansulfonat substituiert ist, dann bevorzugt mit Amino- oder Alkoxygruppen.

Bevorzugt werden Kondensationsprodukte, die sich von ggf. substituierten Diphenylamin-4-diazoniumsalzen, besonders den 3-Methoxy-diphenylamin-4-diazoniumsalzen, ableiten und von diesen die leicht zugänglichen Kondensationsprodukte mit Formaldehyd. Die ggf. vorhandenen Substituenten sind bevorzugt (C₁-C₄)Alkoxy- oder (C₁-C₆)Alkylgruppen. Die Kondensation kann vor allem in konzentrierter Schwefel-, Phosphor- oder Methansulfonsäure, insbesondere in Phosphorsäure durchgeführt werden. Im letzteren Fall kann das Kondensationsprodukt als Rohkondensat, d.h. als die bei der Kondensation anfallende etwa 50%ige Lösung in Phosphorsäure eingesetzt werden. Dies hat den Vorteil, daß die zur Stabilisierung des Kondensationsprodukts im Gemisch bevorzugte Phosphorsäure bereits vorhanden ist. Zur Stabilisierung sind auch Schwefel-, Methansulfon-, p-Toluolsulfon- und Citronensäure geeignet. Ein Überschuß an Säure ist häufig vorteilhaft, so daß auch zusätzlich zu der im Rohkondensat enthaltenen noch mehr Phosphorsäure zugesetzt werden kann.

Das erfindungsgemäße Gemisch enthält ferner ein wasserlösliches amphiphiles Bindemittel, d.h. ein polymeres Bindemittel, das sowohl hydrophile als auch hydrophobe bzw. oleophile Gruppen enthält. Das Polymer hat im allgemeinen ein mittleres Molekulargewicht M_{w} von etwa 5000 bis 100000, bevorzugt von 10000 bis 50000. Besonders vorteilhaft sind Copolymere aus langkettigen, vorzugsweise unverzweigten α-Olefinen, insbesondere solchen mit 10 bis 20 Kohlenstoffatomen, und α,β-ungesättigten Säuren, besonders Acryl- oder Methacrylsäure, die teilweise mit hydrophilen Estergruppen, z.B. Polyoxyethylengruppen mit 6 bis 10 Oxyethyleneinheiten, verestert sind. Die handelsüblichen wasserlöslichen Polymere dieses Typs, z. B. ^{(R)}Dapral GE 202 der Akzo N.V., sind geeignet.

Das erfindungsgemäße Gemisch kann daneben noch ein wasserlösliches, nicht-amphiphiles, polymeres Bindemittel, wie Polyvinylpyrrolidon, enthalten. Ein damit hergestelltes Aufzeichnungsmaterial hat gleich gute Entwicklungseigenschaften wie eines, in dem das zusätzliche Bindemittel fehlt (Beispiel 5). Allerdings nehmen Druckplatten, die mit einem solchen Gemisch hergestellt sind, die Druckfarbe weniger gut an und lassen nur eine deutlich verminderte Druckauflage zu. Vorzugsweise enthält das erfindungsgemäße Gemisch deshalb kein wasserlösliches, nicht-amphiphiles, polymeres Bindemittel.

Neben diesen Polymeren, die selbst auch oberflächenaktiv sind, ist noch mindestens eine niedermolekulare monomere oder oligomere oberflächenaktive Verbindung in dem Gemisch enthalten. Dieser Zusatz bewirkt, daß sich die Platten ohne vorhergehendes Einweichen oder Quellen unmittelbar durch Waschen mit Wasser ohne mechanische Unterstützung schleierfrei entwickeln lassen. Die niedermolekularen Tenside sind bevorzugt nichtionisch und enthalten vorzugsweise Polyoxyalkylenketten mit etwa 3 bis 15 Oxyalkylen-Einheiten. Die Molekulargewichte M_{w} dieser niedermolekularen Verbindungen liegen im allgemeinen im Bereich von 150 bis 2000, bevorzugt von 200 bis 1500. Folgende Typen von oberflächenaktiven Verbindungen sind für die Zwecke der Erfindung besonders geeignet:
Fettalkoholpolyglykolether

[R-O-(C₂H₃R'-O-)ₙH]

Fettsäurepolyglykolester

[R-CO-O-(C₂H₃R'-O-)ₙH]

Alkylphenolpolyglykolether

[R''-C₆H₄-O-(C₂H₃R'-O-)ₙH]

Fettsäureester von höheren Alkanolen R-CO-O-R"
worin
- R: ein C₆-C₂₀-Alkylrest,
- R': Wasserstoff oder Methyl,
- R": ein C₇-C₁₅-Alkylrest, und
- n: eine Zahl von 3 bis 15 ist.

Die Polyglykoletherreste können Polyoxyethylen-, Polyoxypropylen- oder Poly(oxyethylen/oxypropylen)-Reste sein. Mit besonderem Vorteil werden Kombinationen von Fettalkoholpolyglykolethern mit Alkylphenolpolyglykolethern, vorzugsweise in einem Mengenverhältnis von 0,2 bis 5 : 1, eingesetzt.

Den Gemischen können ferner Weichmacher, Haftvermittler, Verlaufmittel, Farbstoffe, Pigmente, Farbbildner und Sensibilisatoren zugesetzt werden. Art und Menge dieser Zusätze richten sich nach dem für das lichtempfindliche Gemisch vorgesehenen Anwendungsgebiet.

Die Farbstoffe und/oder Pigmente können sowohl als Kontrastmittel als auch schichtverfestigend wirken. In Frage kommende Farbstoffe sind beispielsweise in den US-A 3 218 167 und 3 884 693 angegeben. Besonders geeignet sind z.B. Viktoriareinblau FGA, Renolblau B2G-H (C. I. 74160), Kristallviolett oder Rhodamin 6 GDN (C. I. 45160). Zur Erhöhung des Bildkontrasts nach dem Belichten können Metanilgelb (C. I. 13065) oder Phenylazodiphenylamin verwendet werden.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d.h. die Bestandteile der nach dem Verdampfen des Lösemittels erhaltenen festen lichtempfindlichen Schicht.

| | |
|---|---|
| Bindemittel | 10 bis 60, bevorzugt 15 bis 50% |
| Diazoniumsalz-Polykondensationsprodukt | 25 bis 50, bevorzugt 30 bis 40 % |
| Säure | 10 bis 40, bevorzugt 15 bis 30% |
| Oberflächenaktive Substanz | 2 bis 40, bevorzugt 4 bis 20 % |
| Farbstoff oder Pigment | 0 bis 12, bevorzugt 2 bis 8% |

Die Beschichtung des Trägermaterials erfolgt aus entsprechenden organischen Lösemitteln oder Lösemittelgemischen, und zwar im allgemeinen durch Gießen, Sprühen oder Eintauchen.

Als Lösemittel sind Alkohole, Ketone, Ester, Ether und dergleichen geeignet. Als günstige Lösemittel haben sich dabei die Partialether der Glykole oder der Ketoalkohole erwiesen, z. B. Ethylen- oder Propylenglykolmonomethylether.

Die fertige Beschichtungslösung wird auf einen für den Offsetdruck geeigneten Schichtträger aufgetragen, was durch Aufschleudern, Sprühen, Tauchen, Antrag mittels Walzen oder mit Hilfe eines Flüssigkeitsfilms erfolgen kann und sich auch nach den Eigenschaften des zu beschichtenden Materials richtet. Die Schichtdicke der getrockneten Schicht liegt i.a. zwischen 0,1 und 2,0, bevorzugt zwischen 0,2 und 1,0 g/m²; die Trocknungstemperatur sollte bei einer Verweildauer von maximal 2 Minuten im Trockner 120 °C nicht übersteigen.

Als Schichträger sind z. B. Papier, Aluminium, Stahl und Kunststoffolien geeignet. Für die Herstellung von Flachdruckplatten wird vorzugsweise mechanisch, chemisch oder mit Hilfe des elektrischen Stromes aufgerauhtes und/oder anodisiertes Aluminium verwendet, das vorteilhaft vor der Beschichtung in bekannter Weise mit hydrophilierenden Substanzen wie Phosphonsäuren, Silikaten, Fluorozirkonaten, Polyacrylamid etc., insbesondere mit wäßrigen Lösungen von Polyvinylphosphonsäure, vorbehandelt worden ist.

Die Belichtung des Aufzeichnungsmaterials erfolgt in bekannter Weise unter einer Vorlage mit den üblichen Lichtquellen, die einen möglichst hohen Spektralanteil im nahen Ultraviolettbereich emittieren. Sie kann auch durch Bestrahlung mit leistungsgerechten, kürzerwelligen Lasern erfolgen.

Die Strahlung härtet die Schicht an den Stellen aus, auf die das Licht einwirkt und macht sie dadurch weitgehend unlöslich. Die unbelichteten und deshalb löslich bleibenden Teile der Schicht werden durch Abbrausen mit Leitungswasser ohne zusätzliche mechanische Bearbeitung ausgewaschen und entfernt. Eine derartige Entwicklung kann per Handbrause im Entwicklerbecken vorgenommen werden. Bei Verwendung von Entwicklungsmaschinen werden die Platten vorzugsweise durch Einführen in den - soweit vorhanden - separaten Eingang zur Abspülstation vor der Gummierung entwickelt. Diese Vorgehensweise bietet die Möglichkeit zur Verarbeitung von positiv und negativ arbeitenden Druckplatten in einer Verarbeitungsmaschine, was für den Drucker eine erhebliche Einsparung an Kosten und Platzbedarf mit sich bringt. Im Anschluß an die Entwicklung kann die Platte in üblicher Weise gummiert, d.h. mit einem Konservierungsmittel auf der Basis hydrophiler Kolloide, wie Dextrin oder Gummi arabicum etc., beschichtet und später zum Andruck gebracht werden.

Die folgenden Beispiele erläutern bevorzugte Ausführungsformen des erfindungsgemäßen Verfahrens. Prozentangaben sind, wenn nichts anderes angegeben ist, Gewichtsprozente. Als Gewichtsanteil (Gt) ist 1 g zu setzen, wenn als Volumenanteil (Vt) 1 ml gewählt wird.

### Beispiel 1

Beschichtungslösungen aus

| | | |
|---|---|---|
| a) | 14 Gt | eines Diazoniumsalz-Polykondensationsprodukts, hergestellt aus 1 mol 3-Methoxy-diphenylamin-4-diazoniumsulfat und 1 mol Formaldehyd in 85%iger Phosphorsäure, eingesetzt als Rohkondensat (50%ige Lösung in H₃PO₄), |
| | 6 Gt | eines Copolymers aus Acrylsäure und 1,2-Hexadecen (Molverhältnis 2 : 1), dessen Carboxylgruppen zu 50 % mit Polyethylenglykol (6 - 10 Ethylenoxid-Einheiten) verestert sind; mittleres Molekulargewicht M_{w} 20000 (^{(R)}Dapral GE 202 der Akzo N.V.), |
| | 3 Gt | Phosphorsäure (85 %), |
| | 1 Gt | eines Nonylphenolpolyethylenglykolethers mit 30 Ethylenoxideinheiten, |
| | 1 Gt | eines Ethers aus verzweigten primären C₉-C₁₅-Alkoholen und gemischten Polyethern aus 2-8 Oxyethylen- und 1-6 Oxypropyleneinheiten und |
| | 1 Gt | Viktoriablau FBR (Basic Blue 55) in |
| | 634 Gt | Ethanol und |
| | 340 Gt | Diethylenglykolmonomethylether |
| b) | 10 Gt | eines Diazoniumsalz-Polykondensationsprodukts, hergestellt aus 1 mol Diphenylamin-4-diazoniumsulfat und 1 mol Formaldehyd in Phosphorsäure, eingesetzt als Rohkondensat (50%ige Lösung in konz. H₃PO₄), |
| | 8 Gt | des unter (a) angegebenen Copolymers, |
| | 3 Gt | Phosphorsäure (85 %), |
| | 2 Gt | eines Nonylphenolpolyethylenglykolethers mit 15 Ethylenoxideinheiten, |
| | 2 Gt | des unter (a) angegebenen gemischten Polyethers und |
| | 1 Gt | Viktoriablau FBR in |
| | 634 Gt | Ethanol und |
| | 340 Gt | Diethylenglykolmonomethylether |

wurden auf eine in Salzsäure elektrochemisch aufgerauhte und anschließend in Schwefelsäure anodisierte Aluminiumplatte, die zuvor durch kurzes Tauchen in eine wäßrige Polyvinylphosphonsäurelösung (2,2 g/l, 60 °C) nachbehandelt worden war, aufgetragen und bei 100 °C 2 Min. im Umluft-Trockenschrank getrocknet, so daß danach ein Schichtgewicht von 0,3 bis 0,5 g/m² resultierte. Diese Druckplatten wurden nun unter einer Negativvorlage mit einer Metallhalogenidlampe von 5 kW Leistung 50 s belichtet und anschließend durch Abwaschen wahlweise mit destilliertem Wasser oder Leitungswasser entwickelt.

Die Art der Entwicklung umfaßt zwei unterschiedliche Methoden:
I) Abspülen mit der Handbrause und anschließendes kurzes Nachwischen mit einem Plüschtampon o.ä.;
II) Entwickeln in der Abspülstation vor der Gummierstation einer handelsüblichen Offsetplatten-Verarbeitungsanlage mit Abquetschen und Trocknen der Platten (wahlweise mit Gummierung).

Beide Entwicklungsmethoden lieferten im Hinblick auf Tonwertumfang und Halbtonkeil-Deckung übereinstimmende Wiedergaben der Vorlage ohne wesentlichen Farbschleier in den Nichtbildstellen, wobei auch feinste Raster- und Strichelemente differenziert wiedergegeben wurden. Nach der Konservierung wurden die Platten in eine Bogenoffsetmaschine eingespannt und lieferten über 100.000 (1a) bzw. rund 80.000 gute Drucke (1b). Die nach Beispiel 1 hergestellten Aufzeichnungsmaterialien ließen sich in einem Klimaschrank bei 85 % rel. Luftfeuchte und 30-35°C mehr als 24 h und in einem Umluft-Trockenschrank bei 50 °C über 7 Tage lagern, ohne daß die Platten bei der Verarbeitung zur Bildung von Restschleiern in den Nichtbildstellen oder zu wesentlich veränderter Tonwertwiedergabe neigten.

### Beispiel 2

Eine Beschichtungslösung aus

| | |
|---|---|
| 10 Gt | des in Beispiel 1a angegebenen DiazoniumsalzPolykondensationsprodukts, |
| 10 Gt | des in Beispiel 1a angegebenen Copolymers, |
| 2 Gt | Phosphorsäure (85 %), |
| 1 Gt | des in Beispiel 1a angegebenen Nonylphenolethers, |
| 1 Gt | des in Beispiel 1a angegebenen gemischten Polyethers und |
| 1 Gt | Kristallviolett (C. I. 42555) in |
| 635 Gt | Ethanol und |
| 340 Gt | Diethylenglykolmonomethylether |

wurde auf eine in verdünnter wäßriger Salpetersäure elektrochemisch aufgerauhte und wie in Beispiel 1 anodisierte und nachbehandelte Aluminiumplatte aufgetragen, so daß nach dem Trocknen ein Schichtgewicht von 0,3 g/m² erhalten wurde.

Die Verarbeitung wurde wie in Beispiel 1 durchgeführt. Auch hier wurden sehr gut und vollständig entwickelte Druckformen von hoher Auflösung erhalten, die sich im Druck in einer Offsetdruckmaschine durch schnelle Farbannahme (7-10 Bogen) und eine hohe Druckauflage (ca. 80.000 Bogen) auszeichnet. Die Lagerfähigkeit unterschied sich nicht von der der in Beispiel 1 hergestellten Platten.

### Beispiel 3

Die in Beispiel 1a angegebenen Feststoff-Komponenten wurden in 975 g vollentsalztem Wasser gelöst. Die Lösung wurde auf eine wie in Beispiel 1 vorbehandelte Aluminiumplatte aufgebracht. Das Schichtgewicht betrug 0,38 g/m². Das so erhaltene Aufzeichnungsmaterial zeigte im Lagertest bei erhöhter Luftfeuchte selbst nach 48h noch keine wesentlich veränderte Wiedergabe im Vergleich zur Entwicklung frischer Platten. Die kopier- und drucktechnische Leistungsfähigkeit entsprach im wesentlichen der Qualität gemäß Beispiel 1.

### Beispiel 4 (Vergleichsbeispiel)

Eine Beschichtungslösung aus

| | |
|---|---|
| 10 Gt | des in Beispiel 1a angegebenen Diazoniumsalz-Polykondensationsprodukts, |
| 5 Gt | Polyvinylpyrrolidon (^{(R)}Luviskol K 90 der BASF AG), |
| 2 Gt | Phosphorsäure (85 %), |
| 1 Gt | des in Beispiel 1a angegebenen Nonylphenolethers, |
| 2 Gt | des in Beispiel 1a angegebenen gemischten Polyethers und |
| 1 Gt | Viktoriablau FBR in |
| 639 Gt | Ethanol und |
| 340 Gt | Diethylenglykolmonomethylether |

wurde auf eine wie in Beispiel 1 vorbehandelte Aluminiumplatte aufgetragen, so daß nach dem Trocknen ein Schichtgewicht von 0,45 g/m² erhalten wurde.

Beim Entwickeln der belichteten Platte nach Methode I (Beispiel 1) entstand eine Druckform, die auf den Nichtbildstellen einen leichten Blauschleier aufwies, der jedoch beim Anfärben in der Druckmaschine noch nicht zum Tonen führte. Eine reguläre Entwicklung nach Methode II war mit dieser Platte nicht möglich, denn hierbei verblieben an den Nichtbildstellen starke streifenförmige Schichtreste, die beim Andrucken sofort Druckfarbe annahmen.

### Beispiel 5

Der Beschichtungslösung aus Beispiel 4 wurden noch 6 Gt des in Beispiel 1a angegebenen Copolymers zugesetzt und mit dieser modifizierten Lösung Aluminiumplatten gemäß Beispiel 1 beschichtet. Das Schichtgewicht betrug 0,50 g/m². Es wurde ein Aufzeichnungsmaterial erhalten, das sich nach der Belichtung (50 s, 5 kW) sowohl nach Methode I als auch nach Methode II sauber entwickeln ließ und auch deutlich bessere Eigenschaften beim Lagertest unter hoher Luftfeuchte zeigte (nach 24 h bei 85 % r.F./ 30-35 °C noch schleierfrei entwickelbar; die Schicht zeigte dann aber starke Entfärbungserscheinungen).

Beim Vergleich von Farbannahme und Druckauflage mit den Daten für Beispiel 1 zeigten sich jedoch die Nachteile deutlich:

| Beispiel Nr. | Farbannahme (Bogen) | Auflagendruck (Bogen) |
|---|---|---|
| 1a | 10 | > 100.000 |
| 1b | 14 | ca. 80.000 |
| 4 | ca. 100 | ca. 50.000 |
| 5 | ca. 40 | 40-50.000 |

### Beispiel 6 (Vergleichsbeispiel)

a) Eine Beschichtungslösung entsprechend Beispiel 1a wurde ohne den Zusatz des Copolymers angesetzt und auf eine entsprechende Aluminiumplatte zu einem Trocken-Schichtgewicht von 0,35 g/m² aufgebracht. Die erhaltene Kopierschicht ließ sich nach der Belichtung zwar nach Methode I entwickeln, bei Verarbeitung nach Methode II blieben jedoch streifenförmige Restschleier zurück. Eine ordnungsgemäße Entwicklung nach 1-tägiger Feuchtelagerung war nicht mehr möglich. Die Platte zeigte deutliche Restschleier, auch beim Nachwischen. Außerdem trat das Fehlen der Emulgatorwirkung des Copolymers dadurch zu Tage, daß einzelne stärker angefärbte Punkte ("spots") vor allem auf den Nichtbildstellen nach der Entwicklung sichtbar wurden.
b) Aus der Beschichtungslösung von Beispiel 1a wurden statt des Copolymers die beiden niedermolekularen Tenside (je 1 Gt) herausgelassen. Es wurden Aufzeichnungsschichten erhalten, die nur noch nach Methode I schleierfrei entwickelt werden konnten. Im Lagertest sowohl bei 85 % r.F. / 30-35°C über 24 h als auch bei 50 °C im Umluft-Trockenschrank über 3 Tage wiesen diese Platten nach der Entwicklung in den Nichtbildstellen starke Schichtrückstände auf.

## Patentansprüche

1. Lichtempfindliches Gemisch, das ein Polykondensationsprodukt eines aromatischen Diazoniumsalzes, ein polymeres Bindemittel und eine niedermolekulare oberflächenaktive Substanz enthält, dadurch gekennzeichnet, daß das polymere Bindemittel ein wasserlösliches amphiphiles Polymeres mit einem mittleren Molekulargewicht M_{w} von 5000 bis 100.000 ist und daß die oberflächenaktive Substanz mindestens eine nichtionische Verbindung mit einem Molekulargewicht von 150 bis 2000 ist.

2. Lichtempfindliches Gemisch nach Anspruch 1, dadurch gekennzeichnet, daß die niedermolekulare oberflächenaktive Substanz ein Gemisch aus einem Alkylphenolpolyglykolether und einem Ether eines Polyglykols mit einem Alkanol mit 6 bis 20 Kohlenstoffatomen ist.

3. Lichtempfindliches Gemisch nach Anspruch 2, dadurch gekennzeichnet, daß die Polyglykolether Ether von Polyethylen- oder Polypropylenglykolen oder von Mischpolyethern aus Oxyethylen- und Oxypropyleneinheiten sind.

4. Lichtempfindliches Gemisch nach Anspruch 1, dadurch gekennzeichnet, daß das wasserlösliche amphiphile Polymere ein Copolymeres aus Einheiten eines Olefins mit 10 - 20 Kohlenstoffatomen, einer α,β-ungesättigten Carbonsäure und eines Esters dieser Säure mit einem Polyethylenglykol ist.

5. Lichtempfindliches Gemisch nach Anspruch 4, dadurch gekennzeichnet, daß das Polyethylenglykol 6 bis 10 Oxyethyleneinheiten enthält.

6. Lichtempfindliches Gemisch nach Anspruch 1, dadurch gekennzeichnet, daß das Diazoniumsalz-Polykondensationsprodukt wiederkehrende Einheiten R-N₂X enthält, die durch Zwischenglieder miteinander verbunden sind, die von kondensationsfähigen Carbonylverbindungen, insbesondere Formaldehyd, abgeleitet sind, wobei R ein mindestens zwei Benzolringe enthaltender aromatischer Rest und X ein Anion ist.

7. Lichtempfindliches Gemisch nach Anspruch 1, dadurch gekennzeichnet, daß das Diazoniumsalz-Polykondensationsprodukt aus wiederkehrenden Einheiten A-N₂X und B besteht, die durch Zwischenglieder, vorzugsweise Methylengruppen miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

8. Lichtempfindliches Gemisch nach Anspruch 7, dadurch gekennzeichnet, daß das Diazoniumsalz-Polykondensationsprodukt ein Produkt mit wiederkehrenden Einheiten A-N₂X und B ist, die durch zweibindige, von einer kondensationsfähigen Carbonylverbindung abgeleitete Zwischenglieder verbunden sind, wobei die Einheiten A-N₂X sich aus Verbindungen der Formel (R¹-R²-)ₚR³-N₂X ableiten und wobei
X ein Anion, das eine Löslichkeit in Wasser bewirkt,
p eine ganze Zahl von 1 bis 3,
R¹ einen aromatischen Rest mit mindestens einer zur Kondensation mit aktiver Carbonylverbindung befähigten Position,
R² eine Einfachbindung oder eine der Gruppen:
-(CH₂)_{q}-NR⁴-,
-O-(CH₂)ᵣ-NR⁴-,
-S-(CH₂)ᵣ-NR⁴-,
-S-CH₂CO-NR⁴-,
-O-R⁵-O-,
-O-,
-S- oder
-CO-NR⁴-
worin
q eine Zahl von 0 bis 5,
r eine Zahl von 2 bis 5,
R⁴ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
R⁵ eine Arylengruppe mit 6 bis 12 C-Atomen ist, und
R³ einen ggf. substituierten (p+1)-wertigen Benzolrest
bedeuten.

9. Lichtempfindliches Gemisch nach Anspruch 1, dadurch gekennzeichnet, daß es 25 bis 50 Gew.-% Diazoniumsalz-Polykondensationsprodukt, 10 bis 60 Gew.-% polymeres Bindemittel, 2 bis 40 Gew.-% nichtionische oberflächenaktive Verbindung und 10 bis 40 Gew.-% Säure, bezogen auf die nichtflüchtigen Bestandteile, enthält.

10. Lichtempfindliches Aufzeichnungsmaterial für die Herstellung von Druckformen mit einem Schichträger und einer lichtempfindlichen Schicht, dadurch gekennzeichnet, daß die lichtempfindliche Schicht aus einem Gemisch gemäß einem der Ansprüche 1 bis 9 besteht.

11. Verfahren zur Herstellung von Druckplatten, dadurch gekennzeichnet, daß man ein lichtempfindliches Aufzeichnungsmaterial gemäß Anspruch 10 bildmäßig belichtet und die unbelichteten Schichtbereiche mit Wasser auswäscht.

## Claims

1. Photosensitive mixture which contains a polycondensation product of an aromatic diazonium salt, a polymeric binder and a low molecular weight surface-active substance, characterised in that the polymeric binder is a water-soluble, amphiphilic polymer having an average molecular weight M_{w} of 5000 to 100000 and that the surface-active substance is at least one nonionic compound having a molecular weight of 150 to 2000.

2. Photosensitive mixture according to claim 1, characterised in that the low molecular weight surface-active substance is a mixture of an alkylphenol polyglycol ether and an ether of a polyglycol with an alkanol having 6 to 20 carbon atoms.

3. Photosensitive mixture according to claim 2, characterised in that the polyglycol ethers are ethers of polyethylene or polypropylene glycol or of copolyethers of oxyethylene and oxypropylene units.

4. Photosensitive mixture according to claim 1, characterised in that the water-soluble, amphiphilic polymer is a copolymer prepared from units of an olefin having 10-20 carbon atoms, an α,β-unsaturated carboxylic acid and an ester of this acid with a polyethylene glycol.

5. Photosensitive mixture according to claim 4, characterised in that the polyethylene glycol contains 6 to 10 oxyethylene units.

6. Photosensitive mixture according to claim 1, characterised in that the diazonium salt polycondensation product contains repeat units R-N₂X, which are joined together by linking members which are derived from carbonyl compounds capable of condensation, in particular formaldehyde, wherein R is an aromatic residue containing at least two benzene rings and X is an anion.

7. Photosensitive mixture according to claim 1, characterised in that the diazonium salt polycondensation product consists of repeat units A-N₂X and B, which are joined together by linking members, preferably methylene groups, which are derived from carbonyl compounds capable of condensation, wherein A is the residue of an aromatic diazonium compound capable of condensation with formaldehyde and B is the residue of a compound containing no diazonium groups and capable of condensation with formaldehyde, in particular an aromatic amine, a phenol, phenol ether, aromatic thioether, an aromatic hydrocarbon, an aromatic heterocyclic compound or an organic acid amide.

8. Photosensitive mixture according to claim 7, characterised in that the diazonium salt polycondensation product is a product having repeat units A-N₂X and B, which are joined by divalent linking members derived from a carbonyl group capable of condensation, wherein the units A-N₂X are derived from compounds of the formula (R¹-R²-)ₚR³-N₂X and wherein
X means an anion which brings about solubility in water,
p means an integer from 1 to 3,
R¹ means an aromatic residue having at least one position capable of condensation with an active carbonyl compound,
R² means a single bond or one of the groups:
-(CH₂)_{q}-NR⁴-,
-O-(CH₂)ᵣ-NR⁴-,
-S-(CH₂)ᵣ-NR⁴-,
-S-CH₂CO-NR⁴-,
-O-R⁵-O-,
-O-,
-S- or
-CO-NR⁴-
in which
q means a number from 0 to 5,
r means a number from 2 to 5,
R⁴ means hydrogen, an alkyl group having 1 to 5 C atoms, an aralkyl group having 7 to 12 C atoms or an aryl group having 6 to 12 C atoms and
R⁵ means an arylene group having 6 to 12 C atoms and
R³ means an optionally substituted (p+1)-valent benzene residue.

9. Photosensitive mixture according to claim 1, characterised in that it contains 25 to 50 wt.% of diazonium salt polycondensation product, 10 to 60 wt.% of polymeric binder, 2 to 40 wt.% of nonionic surface-active compound and 10 to 40 wt.% of acid, relative to the non-volatile constituents.

10. Photosensitive recording material for the production of a printing member having a layer support and a photosensitive layer, characterised in that the photosensitive layer consists of a mixture according to one of claims 1 to 9.

11. Process for the production of printing plates, characterised in that a photosensitive recording material according to claim 10 is exposed with an image and the unexposed areas of the layer are washed away with water.

## Revendications

1. Mélange photosensible qui contient un produit de polycondensation d'un sel de diazonium aromatique, un liant polymère et une substance tensioactive de faible masse moléculaire, caractérisé en ce que le liant polymère est un polymère amphiphile hydrosoluble ayant une masse moléculaire moyenne Mp de 5 000 à 100 000 et en ce que la substance tensioactive est au moins un composé non ionique ayant une masse moléculaire de 150 à 2 000.

2. Mélange photosensible selon la revendication 1, caractérisé en ce que la substance tensioactive de faible masse moléculaire est un mélange d'un alkylphénolpolyglycoléther et d'un éther d'un polyglycol avec un alcanol de 6 à 20 atomes de carbone.

3. Mélange photosensible selon la revendication 2, caractérisé en ce que les polyglycoléthers sont des éthers de polyéthylène- ou polypropylèneglycols ou des polyéthers mixtes constitués par des unités d'oxyéthylène et d'oxypropylène.

4. Mélange photosensible selon la revendication 1, caractérisé en ce que le polymère amphiphile hydrosoluble est un copolymère constitué par des unités d'une oléfine ayant 10 à 20 atomes de carbone, d'un acide carboxylique α, β-insaturé et d'un ester de cet acide avec un polyéthylèneglycol.

5. Mélange photosensible selon la revendication 4, caractérisé en ce que le polyéthylèneglycol contient 6 à 10 unités d'oxyéthylène.

6. Mélange photosensible selon la revendication 1, caractérisé en ce que le produit de polycondensation de sel de diazonium contient des unités répétées R-N₂X qui sont reliées entre elles par des éléments intermédiaires qui dérivent de composés carbonylés capables de se condenser, en particulier le formaldéhyde, où R est un reste aromatique contenant au moins deux cycles benzéniques et X est un anion.

7. Mélange photosensible selon la revendication 1, caractérisé en ce que le produit de polycondensation sel de diazonium consiste en unités répétées A-N₂X et B qui sont reliées entre elles par les éléments intermédiaires, de préférence des groupes méthylènes, qui dérivent de composés carbonylés capables de se condenser, où A est le reste d'un composé de diazonium aromatique capable de se condenser avec le formaldéhyde et B est le reste d'un composé sans groupes diazonium, capable de se condenser avec le formaldéhyde, en particulier une amine aromatique, un phénol, un phénoléther, un thioéther aromatique, un hydrocarbure aromatique, un composé hétérocyclique aromatique ou un amide d'acide organique.

8. Mélange photosensible selon la revendication 7, caractérisé en ce que le produit de polycondensation de sel de diazonium est un produit ayant des unités répétées A-N₂X et B qui sont reliées par des éléments intermédiaires divalents dérivés d'un composé carbonylé capable de se condenser, où les unités A-N₂X dérivent de composés de formule (R¹-R²-)ₚR³-N₂X, et où
X représente un anion qui confère une solubilité dans l'eau,
p représente un nombre entier de 1 à 3,
R¹ représente un reste aromatique ayant au moins une position capable de se condenser avec un composé carbonylé actif,
R² représente une liaison simple ou l'un des groupes :
-(CH₂)_{q}-NR⁴-,
-O-(CH₂)ᵣ-NR⁴-,
-S-(CH₂)ᵣ-NR⁴-,
-S-CH₂-CO-NR⁴-,
-O-R⁵-O-,
-O-,
-S- ou
-CO-NR⁴-
où
q est un nombre de 0 à 5,
r est un nombre de 2 à 5,
R⁴ est l'hydrogène, un groupe alkyle ayant 1 à 5 atomes de carbone, un groupe aralkyle ayant 7 à 12 atomes de carbone ou un groupe aryle ayant 6 à 12 atomes de carbone, et
R⁵ est un groupe arylène ayant 6 à 12 atomes de carbone, et
R³ est un reste benzénique (p+1)valent éventuellement substitué.

9. Mélange photosensible selon la revendication 1, caractérisé en ce qu'il contient 25 à 50 % en masse de produit de polycondensation de sel de diazonium, 10 à 60 % en masse de liant polymère, 2 à 40 % en masse de composé tensioactif non ionique et 10 à 40 % en masse d'acide, par rapport aux constituants non volatils.

10. Matériau d'enregistrement photosensible pour la fabrication de formes d'impression comportant un support de couches et une couche photosensible, caractérisé en ce que la couche photosensible consiste en un mélange selon l'une des revendications 1 à 9.

11. Procédé de fabrication de plaques d'impression, caractérisé en ce que l'on insole selon une image un matériau d'enregistrement photosensible selon la revendication 10 et on élimine par lavage à l'eau les domaines de couche non insolés.
